# FASCICULE DE BREVET EUROPEEN

(11) **EP 3 588 505 B1**
(45) Date de publication et mention de la délivrance du brevet: **21.10.2020**
(21) Numéro de dépôt: 19182867.2
(22) Date de dépôt: 27.06.2019
(51) Int. Cl.: G11C 29/56, G11C 29/06, G11C 29/00, G11C 29/04, G11C 29/50

(54) **ÉQUIPEMENT DE DÉVERMINAGE DE COMPOSANTS ÉLECTRONIQUES**
AUSRÜSTUNG ZUM EINBRENNEN VON ELEKTRONISCHEN KOMPONENTEN
BURN-IN EQUIPMENT FOR ELECTRONIC COMPONENTS

(30) Priorité: 29.06.2018 FR 1855957
(43) Date de publication de la demande: 01.01.2020
(73) Titulaire: 3D Plus, 78530 Buc Cedex (FR)
(72) Inventeur: Boussadia, Mohamed, 78190 TRAPPES (FR)
(74) Mandataire: Marks & Clerk France

(56) Documents cités:
- CN-B- 101 859 718
- US-A1- 2007 269 911
- US-A1- 2016 139 198
- US-A1- 2016 334 462
- US-A1- 2018 059 174

## Description

Le domaine de l'invention est celui du déverminage (Burn-In en anglais) de composants électroniques fonctionnant notamment à de hautes fréquences. On entend plus particulièrement par déverminage, une séquence de contraintes thermiques et électriques, ayant pour but de faire vieillir de manière accélérée ces composants électroniques, afin d'éliminer les défauts de jeunesse lors de leur production.

Certains nouveaux composants électroniques apparus récemment sur le marché ont comme contrainte opérationnelle d'avoir une fréquence minimale de fonctionnement garantie, ce qui n'était pas exigé pour les anciens composants. Cette fréquence minimale de fonctionnement est typiquement d'environ 300 MHz. Parmi ces nouveaux composants, on peut citer des mémoires vives SDRAM de type DDR3 (ou DDR3 SDRAM acronyme de l'expression anglo-saxonne Double Data Rate 3rd generation Synchronous Dynamic Random Access Memory, signifiant mémoire à accès direct synchrone à débit de données doublé de troisième génération), DDR4 ou plus.

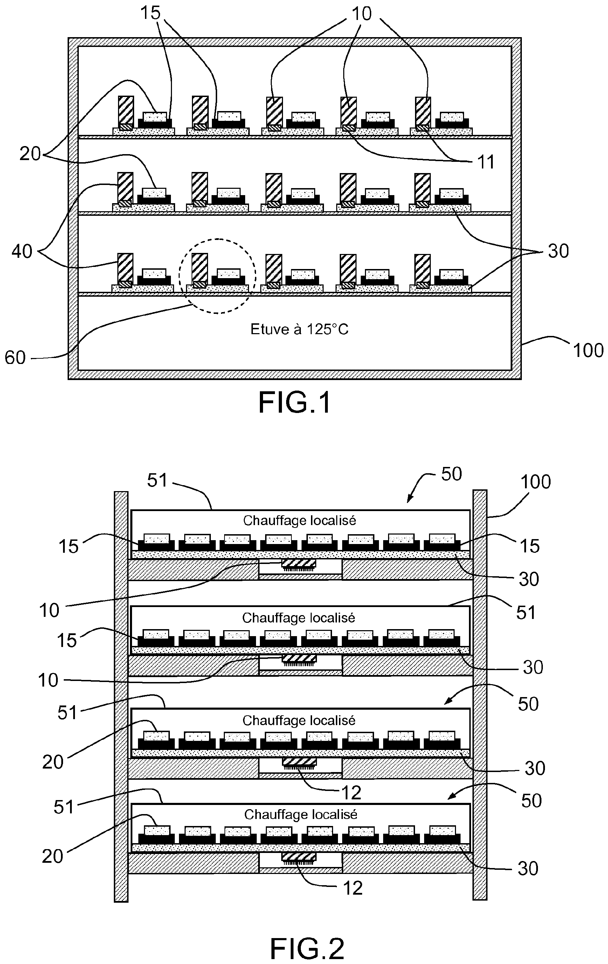

Sur le marché du vieillissement des composants électroniques nous distinguons actuellement deux approches différentes :
- chez les fabricants (les fondeurs) : une approche permettant un déverminage à basse fréquence (<20MHz).
- utilisation de boîtiers de déverminage développés par la société BiBench dont un exemple est montré figure 1. La procédure de déverminage est pilotée par un circuit électronique 10 de pilotage du déverminage désigné « Burn-In driver » qui est connecté par un connecteur 11 au composant 20 à déverminer. Ce circuit 10 a pour fonction de piloter une séquence de contraintes électriques dans un environnement contraint thermiquement (via l'utilisation d'une étuve 100). Plus précisément, le composant 20 est placé dans un socket 15 monté sur un PCB 30 (acronyme de l'expression anglo-saxonne Printed Circuit Board), et est relié au connecteur 11 via ce PCB. On rappelle que pour pouvoir atteindre la fréquence de fonctionnement minimale requise (300 MHz), la distance driver-composant doit être réduite (typiquement inférieure à 8 cm). Plusieurs ensembles driver-connecteur-PCB-socket 60 sont placés dans une étuve à 125°C, cette étuve 100 ayant une double fonction de support de ces ensembles et de chambre chaude. Mais s'il est nécessaire que le composant soit soumis à cette température, il est en revanche indispensable de protéger le driver de cette température. C'est pourquoi le driver 10 (et son connecteur 20) est lui-même placé dans un boîtier refroidi 40 ayant une double fonction : l'isoler de la température ambiante de l'étuve (125 °C) et évacuer l'énergie thermique de fonctionnement du driver. La température interne au boîtier refroidi est régulée par un système de refroidissement. Cette solution est techniquement très intéressante mais possède deux principales limitations : ne répond pas à la problématique d'un environnement de production industrielle (grand nombre de composants) car trop orientée laboratoire (un ou deux composants par driver) et donc trop couteuse en coût récurrent (« recurring expense »).

Actuellement l'ensemble des solutions de Burn-In existant sur le marché sont donc limitées en terme de fréquence de fonctionnement (<125MHz) ou pour celles qui répondent à la contrainte de fréquence minimale (300 MHz), leur mise en application ne remplit pas les conditions d'industrialisation.

CN101859718 B divulgue un équipement de déverminage de composants électroniques qui comprend plusieurs ensembles.

US2007/269911 A1 divulgue une méthode à contrôler la dissipation d'énergie des circuits du pilotage d'un équipement de déverminage de circuits mémoire. US2018/059174 A1 divulgue un équipement de déverminage de circuits mémoire ayant une seule chambre régulée à une température T° > 80 °C.

Le but de l'invention est de pallier ces inconvénients. En conséquence, il demeure à ce jour un besoin pour un équipement donnant simultanément satisfaction à l'ensemble des exigences précitées, en termes de nombre de composants électroniques à déverminer, et de coût de leur déverminage. L'invention est définie par l'objet de la revendication indépendante 1. D'autres modes de réalisation préférées sont définies par l'objet des revendications dépendantes.

Plus précisément l'invention a pour objet un équipement de déverminage de composants électroniques qui comprend plusieurs ensembles placés dans un support, chaque ensemble comportant un circuit imprimé sur lequel sont placés des sockets destinés à recevoir des composants électroniques et un circuit de pilotage du déverminage. Il est principalement caractérisé en ce que le support est à température ambiante, en ce que chaque ensemble comporte une seule chambre régulée à une température T° > 80 °C dans laquelle sont placés au moins quatre sockets, le circuit imprimé formant une paroi de la chambre, en ce que le circuit de pilotage du déverminage est directement soudé sur le circuit imprimé côté extérieur à la chambre, avec un seul circuit de pilotage du déverminage par chambre, et en ce que l'ensemble comporte en outre des moyens de dissipation de seulement l'énergie thermique de fonctionnement du circuit de pilotage du déverminage.

Avantageusement, la température T° de régulation d'une chambre varie d'une chambre à l'autre.

Chaque chambre comporte typiquement 4 à 20 sockets.

La distance sur le circuit imprimé entre le circuit de pilotage du déverminage et les composants électroniques les plus proches du circuit de pilotage du déverminage, est de préférence inférieure à 8 cm.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement un exemple d'équipement de déverminage selon l'état de la technique,
la figure 2 représente schématiquement un exemple d'équipement de déverminage selon l'invention,

D'une figure à l'autre, les mêmes éléments sont repérés par les mêmes références.

On décrit en relation avec la figure 2 un exemple d'équipement de déverminage selon l'invention. Il comporte un support 100 dans lequel sont fixés plusieurs ensembles de déverminage. Ce support ouvert ou fermé est à température ambiante. Chaque ensemble 50 comporte :
- une seule chambre 51 régulée à une température T° > 80 °C,
- un circuit imprimé 30 ou PCB éventuellement multicouche, formant une paroi de la chambre 51 ; sur la face du PCB côté chambre, sont placés des sockets 15 destinés à recevoir les composants électroniques 20 à déverminer, avec un socket par composant.
- un circuit 10 de pilotage du déverminage (= Burn-In driver) avec un seul circuit de pilotage du déverminage par chambre ; le circuit est directement soudé sur le PCB 30 côté extérieur à la chambre, c'est-à-dire sans utiliser de connecteur généralement limité en nombre d'entrée-sorties par rapport au nombre d'entrée-sorties des composants électroniques. En effet, un connecteur de 66 entrée-sorties par exemple ne permettra pas au circuit de pilotage de balayer toutes les 72 entrée-sorties d'une mémoire DDR3. Alors qu'en connectant directement le circuit de pilotage sur un PCB multicouches, on peut aisément concevoir dans le PCB autant de pistes (460 par exemple) reliant chaque entrée-sortie du composant 20 au circuit de déverminage 10. Ce circuit 10 de déverminage qui est situé à l'extérieur de la chambre chaude, est donc à température ambiante. Il est situé sur le PCB de manière à ce que la distance entre le circuit 10 et les composants électroniques 20 les plus proches du circuit soit inférieure à 8 cm afin d'atteindre ou dépasser la fréquence de fonctionnement requise de 300 MHz.
- des moyens 12 de dissipation de seulement l'énergie thermique de fonctionnement du circuit de déverminage 10. En effet celui-ci n'étant plus situé dans une étuve à 125°C, mais étant à température ambiante, il n'est plus nécessaire d'utiliser des moyens de refroidissement à double fonction comme ceux décrits en relation avec la figure 1 ; il en résulte une économie d'énergie. Ces moyens qui ont uniquement la fonction classique de dissiper l'énergie thermique dégagée par le circuit de déverminage lors de son fonctionnement, sont des moyens habituels.

Comme on peut le voir sur la figure, plusieurs ensembles 50 sont installés dans le support 100. La régulation en température peut varier d'une chambre à l'autre : une chambre 51 hébergeant certains composants 20 peut par exemple être régulée à une première température 80°C par exemple, une autre chambre 51 hébergeant d'autres composants 20 étant régulée à une autre température 125°C par exemple. En outre la température de chaque chambre 51 est très homogène; on obtient 1°C de différence maximum entre les différents composants hébergés dans une chambre, alors que dans une étuve classique, on obtient au mieux une différence de 4°C entre les composants selon qu'ils sont installés au fond ou au bord de l'étuve. Les composants électroniques d'une chambre sont identiques, mais les composants électroniques placés dans une chambre peuvent être différents de ceux d'une autre chambre ; on peut avantageusement déverminer en même temps différents composants électroniques dans le même support. On peut par exemple déverminer des mémoires DDR3 dans un premier ensemble en régulant la chambre à 125 °C, des mémoires DDR4 dans un deuxième ensemble en régulant aussi la chambre à 125 °C, des processeurs dans un troisième ensemble en régulant la chambre à 100 °C, etc. Un support comporte typiquement entre 2 et 200 ensembles, voire plus.

Le fonctionnement de cet équipement est économique dans la mesure où seul le volume des chambres est régulé en température et non tout le volume d'une étuve.

## Revendications

1. Equipement de déverminage de composants électroniques (20) qui comprend plusieurs ensembles (50) placés dans un support (100), chaque ensemble comportant un circuit imprimé (30) sur lequel sont placés des sockets (15) destinés à recevoir des composants électroniques (20) comprenant au moins une mémoire SDRAM DDR3 ou plus, et un circuit (10) de pilotage du déverminage, le support (100) étant à température ambiante, chaque ensemble comportant une seule chambre (51) régulée à une température T° > 80 °C dans laquelle sont placés au moins quatre sockets (15), le circuit imprimé (30) formant une paroi de la chambre, le circuit (10) de pilotage du déverminage étant directement soudé sur le circuit imprimé côté extérieur à la chambre, avec un seul circuit (10) de pilotage du déverminage par chambre, et l'ensemble comportant en outre des moyens (12) de dissipation de seulement l'énergie thermique de fonctionnement du circuit de pilotage du déverminage, où la distance sur le circuit imprimé (30) entre le circuit (10) de pilotage du déverminage et les sockets (15) les plus proches du circuit de pilotage du déverminage est inférieure à 8 cm.

2. Equipement de déverminage selon la revendication précédente, **caractérisé en ce que** la température T° de régulation d'une chambre varie d'une chambre à l'autre.

3. Equipement de déverminage selon l'une des revendications précédentes, **caractérisé en ce que** chaque chambre (51) comporte 4 à 20 sockets (15).

## Patentansprüche

1. Gerät (20) zum Einbrennen elektronischer Komponenten, das mehrere in einem Träger (100) platzierte Baugruppen (50) umfasst, wobei jede Baugruppe eine gedruckte Schaltung (30) aufweist, auf der Sockel (15) zur Aufnahme elektronischer Komponenten (20) angeordnet sind, die mindestens einen DDR3- oder höheren SDRAM-Speicher umfassen, und eine Einbrennsteuerschaltung (10), wobei der Träger (100) auf Umgebungstemperatur ist, wobei jede Baugruppe eine einzige Kammer (51) aufweist, die auf eine Temperatur T° > 80°C geregelt ist und in der mindestens vier Sockel (15) platziert sind, wobei die gedruckte Schaltung (30) eine Wand der Kammer bildet, wobei die Einbrennsteuerschaltung (10) direkt auf die gedruckte Schaltung auf der Außenseite der Kammer gelötet ist, wobei nur eine Einbrennsteuerschaltung (10) pro Kammer vorhanden ist, und wobei die Baugruppe ferner Mittel (12) zum Ableiten nur der thermischen Energie des Betriebs der Einbrennsteuerschaltung aufweist, wobei der Abstand auf der gedruckten Schaltung (30) zwischen der Einbrennsteuerschaltung (10) und den der Einbrennsteuerschaltung am nächsten liegenden Sockeln (15) weniger als 8 cm beträgt.

2. Einbrenngerät nach dem vorherigen Anspruch, **dadurch gekennzeichnet, dass** die Regeltemperatur T° einer Kammer von einer Kammer zur anderen variiert.

3. Einbrenngerät nach einem der vorherigen Ansprüche, **dadurch gekennzeichnet, dass** jede Kammer (51) 4 bis 20 Sockel (15) aufweist.

## Claims

1. Apparatus for burning in electronic components (20), which comprises several assemblies (50) placed in a holder (100), each assembly comprising a printed circuit board (30) on which are placed sockets (15) intended to receive electronic components (20) comprising at least one DDR3 - or higher - SDRAM memory, and a burn-in driver circuit (10), the holder (100) being at room temperature, each assembly comprising a single chamber (51) that is regulated to a temperature T° > 80 °C, in which at least four sockets (15) are placed, the printed circuit board (30) forming one wall of the chamber, the burn-in driver circuit (10) being soldered directly to the printed circuit board on the outer side of the chamber, with a single burn-in driver circuit (10) per chamber, and the assembly furthermore comprising means (12) for dissipating only the thermal energy of operation of the burn-in driver circuit, wherein the distance on the printed circuit board (30) between the burn-in driver circuit (10) and the sockets (15) closest to the burn-in driver circuit is smaller than 8 cm.

2. Burn-in apparatus according to the preceding claim, **characterized in that** the regulation temperature T° of a chamber varies from one chamber to the next.

3. Burn-in apparatus according to one of the preceding claims, **characterized in that** each chamber (51) comprises 4 to 20 sockets (15).
